# FASCICULE DE BREVET EUROPEEN

(11) **EP 3 196 947 B1**
(45) Date de publication et mention de la délivrance du brevet: **18.08.2021**
(21) Numéro de dépôt: 17151899.6
(22) Date de dépôt: 18.01.2017
(51) Int. Cl.: H01L 31/024, H01L 31/103, F25D 19/00, C22C 45/10, C22C 30/02, G01J 5/06, G01J 5/04, G01J 1/02

(54) **DISPOSITIF REFROIDISSEUR COMPORTANT UN DOIGT FROID AMELIORE**
KÜHLVORRICHTUNG, DIE EINEN VERBESSERTEN KRYOSTATFINGER UMFASST
COOLING DEVICE COMPRISING AN IMPROVED COLD FINGER

(30) Priorité: 20.01.2016 FR 1650457
(43) Date de publication de la demande: 26.07.2017
(73) Titulaire: LYNRED, 91120 Palaiseau (FR); Université Grenoble Alpes, 38400 Saint-Martin-d'Hères (FR)
(72) Inventeur: Cassaigne, Pierre, 38100 Grenoble (FR); Lenain, Alexis, 38000 Grenoble (FR); Gravier, Sébastien, 38400 Saint Martin d'Hères (FR)
(74) Mandataire: Talbot, Alexandre

(56) Documents cités:
- US-A- 5 032 196
- US-A1- 2015 021 477
- ZHANG H ET AL: "Mechanical behavior of bulk (ZrHf)TiCuNiAl amorphous alloys", SCRIPTA MATERIALIA, ELSEVIER, AMSTERDAM, NL, vol. 49, no. 5, septembre 2003 (2003-09), pages 447-452, XP004431953, ISSN: 1359-6462, DOI: 10.1016/S1359-6462(03)00295-1

## Description

### Domaine technique de l'invention

L'invention concerne un dispositif refroidisseur comportant un doigt froid fermé par une platine de refroidissement.

### État de la technique

Dans le domaine des dispositifs de détection, il y a communément un photodétecteur associé à un circuit de lecture. Le photodétecteur délivre un signal représentatif de la scène observée et ce signal est traité par le circuit de lecture.

La polarisation du photodétecteur est obtenue au moyen d'un potentiel de substrat imposé sur une première borne du photodétecteur et au moyen d'un potentiel de référence imposé sur la seconde borne du photodétecteur. Le potentiel de référence est imposé par un dispositif de lecture de type amplificateur transimpédance capacitif.

Afin d'obtenir des performances de détection importantes, il est intéressant d'utiliser des substrats particuliers, par exemple à base de Mercure, Cadmium, Tellure et de faire fonctionner ces équipements à basse température. L'utilisation d'une basse température permet de limiter les perturbations électriques parasites lors de la transformation du signal optique en un signal électrique.

De manière classique, le circuit de détection est associé thermiquement à un dispositif de refroidissement qui réalise l'évacuation de la chaleur.

Un tel dispositif comporte principalement une pièce creuse et de forme allongée, préférentiellement cylindrique de révolution, qui est appelée « doigt froid ». Le doigt froid autorise la connexion thermique entre d'une part le dispositif de détection qui est à refroidir et le système de refroidissement, par exemple un cryogénérateur qui permet d'amener le dispositif de détection à sa température de fonctionnement et d'assurer son maintien à cette température, en assurant une isolation thermique maximale entre la partie haute qui est à plus basse température et la partie basse qui est plus chaude.

De manière classique, il est intéressant de réaliser un doigt froid qui présente des parois aussi fines que possible. La diminution des dimensions du doigt froid et notamment de l'épaisseur des parois permet de diminuer la conductance thermique du doigt froid. Pour exemple, pour un doigt ayant une hauteur de 50 mm et un diamètre extérieur de 6 à 10 mm, les parois ont une épaisseur de l'ordre de 0.1 mm. Les doigts froids sont généralement réalisés en alliage de titane TA6V qui présente les performances mécaniques nécessaires au bon fonctionnement du doigt froid ainsi que des performances thermiques acceptables.

L'utilisation de parois fines évite une dépense d'énergie frigorifique trop importante de la part du système de refroidissement en diminuant les fuites thermiques. L'utilisation de parois fines permet de réduire les fuites thermiques en augmentant la résistance thermique liée aux parois. La perte d'énergie frigorifique délivrée par le système de refroidissement à d'autres éléments que le dispositif de détection est ainsi minimisée. La température de fonctionnement est donc maintenue plus facilement, avec une dépense d'énergie frigorifique superflue aussi faible que possible. Une diminution de l'épaisseur des parois permet donc d'améliorer le rendement.

Cependant cette architecture est difficile à mettre en œuvre et les performances finales du dispositif ne sont pas satisfaisantes.

Il a été observé que si les parois du doigt froid sont trop fines, elles ne sont plus suffisamment rigides pour éviter une déformation du doigt froid lors de son fonctionnement. Cette déformation du doigt froid se traduit par une perte importante des performances optiques du dispositif de détection et notamment à causes des vibrations liées au système de refroidissement.

En plus des contraintes thermiques, sur le doigt froid, il est également nécessaire de prendre en considération des contraintes mécaniques qui se manifestent par la vibration de la partie sommitale du doigt froid qui comporte une platine de refroidissement avec l'élément à refroidir.

L'alliage de TA6V est intéressant car il présente de bonnes performances mécaniques pour lutter contre les phénomènes de vibration. Les performances de l'alliage contre les phénomènes de vibration sont représentées par le rapport entre le module de Young et la masse volumique.

Les mêmes problèmes existent de manière générale sur tous dispositifs refroidisseurs utilisant un doigt froid et plus particulièrement pour les cryostats car ces derniers doivent refroidir un élément spécifique.

Le document US 2015/021477 traite d'un doigt froid dans le domaine des dispositifs de détection. Ce document propose d'utiliser un doigt froid qui comporte un alliage métallique amorphe afin d'augmenter le caractère isolant par rapport aux doigts froids connus.

La publication de Zhang et al « Mechanical behavior of bulk (ZrHf)TiCuNiAl amorphous alloys » (Scripta Materialia, Elsevier, Amsterdam, NL, vol. 49, n°5, 1 septembre 2003) traite des propriétés thermodynamique et mécanique des alliages amorphes massifs à base de Zr/Hf pour déterminer les température de cristallisation de transition vitreuse. Il a été observé que la dureté et le module augmentent avec la teneur en Hf.

### Objet de l'invention

On constate qu'il existe un besoin de prévoir un dispositif refroidisseur qui est plus performant thermiquement tout en conservant une réalisation simple et robuste et les performances mécaniques nécessaires. Un des autres buts de l'invention est de proposer un cryostat dans lequel les pertes thermiques sont réduites au minimum et notamment vis-à-vis des modes de réalisation du document US 2015/021477.

On tend à atteindre cet objectif au moyen d'un dispositif refroidisseur qui comporte
- une platine de refroidissement,
- un système de refroidissement muni d'un fluide de refroidissement,
- un doigt froid creux et fermé à une extrémité par la platine de refroidissement, le fluide de refroidissement étant localisé dans le doigt froid pour refroidir la platine de refroidissement, le doigt froid comportant au moins une paroi latérale définissant un canal de confinement du fluide de refroidissement depuis le système de refroidissement.

Le dispositif est remarquable en ce que:
- ladite au moins une paroi latérale est formée au moins partiellement par une zone en alliage métallique au moins partiellement amorphe,
- la zone en alliage métallique au moins partiellement amorphe est formée par un alliage au moins ternaire contenant au moins 17,5% atomique d'hafnium et éventuellement du cuivre avec une teneur maximale égale à 40% atomique de cuivre de manière à former un isolant thermique.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente en coupe, de manière schématique un cryostat monté dans un dispositif de détection comportant un détecteur couplé à un système de refroidissement,
- les figures 2 et 3 représentent, de manière schématique, en coupe, deux modes de réalisation d'un doigt froid,
- la figure 4 représente en coupe, de manière schématique une variante de réalisation d'un dispositif de détection muni d'un cryostat.

### Description de modes préférentiels de réalisation

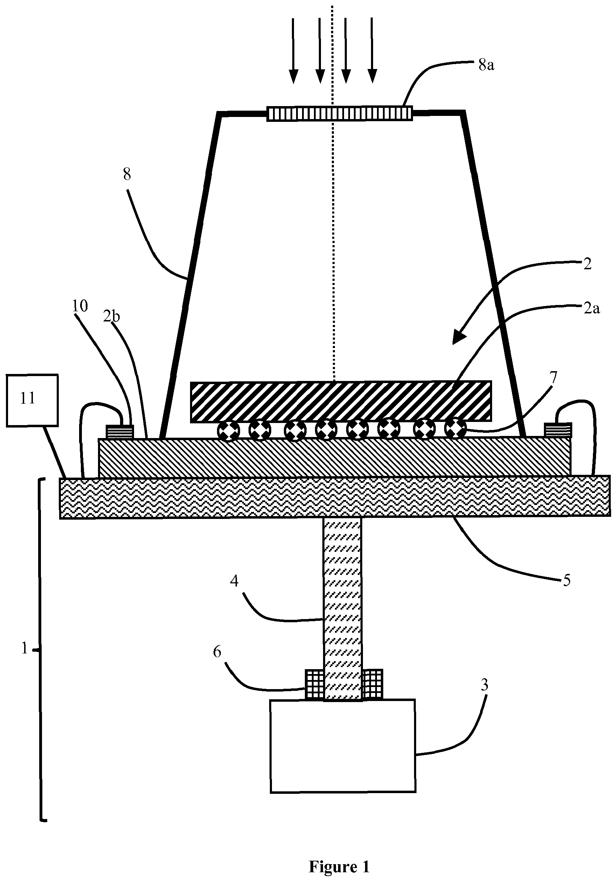

La figure 1 représente schématiquement un dispositif refroidisseur 1 et plus précisément un dispositif refroidisseur 1 connecté à un détecteur 2 pour former un dispositif de détection refroidi.

Le dispositif refroidisseur 1 comporte un système de refroidissement 3 et un doigt froid 4 terminé par une platine de refroidissement 5. L'élément à refroidir est disposé sur la platine de refroidissement 5 et est en contact avec la platine de refroidissement 5 de manière à être refroidi au moyen du système de refroidissement 3 et plus précisément au moyen d'un fluide de refroidissement qui circule à l'intérieur du doigt froid 4.

Le dispositif refroidisseur comporte un doigt froid 4 qui assure la connexion mécanique et l'isolation thermique entre la platine de refroidissement 5 et le système de refroidissement 3. Dans l'exemple illustré, l'élément à refroidir est un détecteur.

Le doigt froid 4 relie mécaniquement le système de refroidissement 3 avec la platine de refroidissement 5. Le système de refroidissement 3 fonctionne au moyen d'un fluide de refroidissement disposé à l'intérieur du doigt froid 4. Le fluide de refroidissement est à basse température de manière à refroidir le détecteur 2. De manière avantageuse, le système de refroidissement 3 est configuré pour que la température du fluide de refroidissement soit inférieure à -20°C, de préférence inférieure à 220K et de manière encore plus préférentielle inférieure à 150K.

De manière générale, le système de refroidissement 3 utilise un fluide sous pression qui est confiné et qui circule à l'intérieur du doigt froid 4. Le fluide de refroidissement réalise le transfert thermique entre la platine de refroidissement 5 et le système de refroidissement 3. Le doigt froid 4 permet de canaliser le fluide de refroidissement entre la platine de refroidissement 5 et le système de refroidissement 3.

Le doigt froid 4 est une pièce creuse de forme allongée. Préférentiellement, le doigt froid 4 est de forme cylindrique et de révolution. Une extrémité du doigt 4 est en contact thermique avec la platine de refroidissement 5 et l'autre extrémité est en contact mécanique avec le système de refroidissement 3 qui est à une température plus importante. Le doigt froid 4 a également une interface avec le système de refroidissement 3, par exemple un cryogénérateur.

Il existe un gradient de température le long du doigt froid 4. Dans une variante de réalisation, l'extrémité du doigt froid 4 forme la platine de refroidissement 5. Le doigt froid 4 et la platine de refroidissement 5 sont avantageusement réalisés dans le même matériau ce qui facilite la tenue mécanique de ces deux éléments sur une plage de température importante. L'extrémité du doigt froid 4 en contact avec l'élément à refroidir fournit la puissance frigorifique créée par la détente du fluide de refroidissement.

Comme indiqué précédemment, la platine 5 est connectée mécaniquement à son système de refroidissement 3 ce qui autorise des transferts de chaleur préjudiciables au bon refroidissement de l'élément présent sur la platine de refroidissement 5. Pour assurer un bon refroidissement, le doigt froid 4 est isolant thermiquement entre ses deux extrémités opposées de manière à minimiser les fuites thermiques qui existent entre la platine de refroidissement 5 et son système de refroidissement 3.

L'embase du doigt froid 4 assure préférentiellement l'interface mécanique et l'étanchéité entre le doigt froid 1 et le système de refroidissement 3.

Le système de refroidissement 3 peut être une machine à détente connue (communément nommé « Joule Thomson ») ou alors une machine cyclique connue, par exemple une machine utilisant le cycle de Stirling. Le système de refroidissement 3 peut comporter un oscillateur de pression qui génère une onde de pression dans un fluide et le fluide est successivement comprimé et détendu.

Le système de refroidissement 3 comprend un oscillateur électromécanique qui génère, dans une enceinte active contenant un fluide, une onde de pression. Le fluide est avantageusement un gaz. L'enceinte comporte une partie munie d'un régénérateur mobile ou déplaceur qui utilise les cycles de détente et de compression du fluide pour réaliser un cycle de Stirling.

L'enceinte est formée par l'intérieur du doigt froid 4 et la détente permet de refroidir une extrémité du doigt froid 4 (le haut du doigt froid sur les figures) et ainsi la platine de refroidissement. Le doigt froid 4 comporte au moins une paroi latérale définissant un canal de confinement du fluide de refroidissement depuis le système de refroidissement 3. Selon les modes de réalisation, la pression dans le doigt froid 4 peut être importante, par exemple entre 2 bar et 10 bar éventuellement jusqu'à 30 bar ou plus.

Pour améliorer les performances du dispositif refroidisseur 1, il est intéressant de limiter les transferts de chaleur entre le système de refroidissement 3 et la platine de refroidissement 5. Il est particulièrement intéressant de placer un isolant thermique entre les deux extrémités opposées du doigt froid 4.

Cette précaution permet de maintenir plus facilement l'isolation thermique entre la partie supérieure du doigt froid 4, par exemple à température cryogénique, et la partie inférieure du doigt froid qui est à une température supérieure, par exemple la température ambiante.

Le doigt froid 4 comporte au moins une paroi latérale qui forme les côtés du doigt. Les côtés du doigt froid 4 peuvent être décomposés en une paroi latérale ou en plusieurs parois latérales. Le doigt froid 4 est terminé par la platine de refroidissement 5 qui vient fermer le doigt froid 4.

Les parois latérales du doigt froid 4 comportent au moins une partie formée par un alliage métallique au moins partiellement amorphe, c'est-à-dire un matériau métallique non cristallin qui présente une structure atomique désordonnée. Par alliage métallique au moins partiellement amorphe, on entend un matériau comprenant au moins 50 % volumique de matériau amorphe, le reste du matériau étant à l'état polycristallin. Il est avantageux que le matériau contienne au moins 50% volumique de phase amorphe car cela permet de réaliser un matériau moins fragile. De manière particulièrement avantageuse, le matériau comprend au moins 90% volumique de phase amorphe de manière à avoir un matériau avec les performances mécaniques et thermiques optimales. Ce choix particulier permet une nette amélioration des performances en comparaison des doigts froids en alliages métalliques poly-cristallins de l'art antérieur. L'amélioration du caractère isolant du doigt froid est obtenue en utilisant un matériau qui présente une conductibilité thermique plus faible que l'alliage de TA6V utilisé dans l'art antérieur.

Par conductivité thermique ou conductibilité thermique on entend la grandeur physique caractérisant le comportement des matériaux lors du transfert thermique par conduction. Par abus de langage, le terme de résistivité thermique pourra être utilisé pour caractériser la grandeur physique traduisant le comportement des matériaux s'opposant au transfert thermique par conduction. Cependant, cette formulation est à dissocier de la notion de résistance thermique utilisée couramment par les métallurgistes travaillant dans le domaine des alliages métalliques amorphes et traduisant l'écart de température qui existe entre la température ambiante et la température de transition vitreuse. Cet écart de température correspond à la plage de température dans laquelle l'alliage métallique amorphe peut être utilisé. Un alliage métallique amorphe résistant est donc un alliage ayant une température de transition vitreuse élevée. Par exemple, le document US 5,032,196 présente la résistance thermique comme la différence de température qui existe entre la température de fusion et la température de transition vitreuse.

Ainsi, au moins une paroi latérale est formée au moins partiellement par une zone en alliage métallique amorphe. De manière particulièrement avantageuse, l'alliage métallique amorphe est un alliage à base d'hafnium. L'alliage métallique amorphe forme l'isolant thermique qui empêche ou ralentit le transfert de chaleur depuis l'extrémité du doigt froid 4 connectée au système de refroidissement 3 vers l'extrémité connectée à la platine de refroidissement 5.

Les inventeurs ont découvert qu'un alliage métallique amorphe à base d'hafnium est particulièrement intéressant pour former au moins une partie d'un doigt froid. En effet, cela permet de réduire notablement la conductibilité thermique par rapport aux alliages cristallins utilisés couramment pour former les doigts froids. Ces alliages permettent également de réduire notablement la conductibilité thermique par rapport aux autres alliages métalliques réalisés sous forme amorphe.

Les alliages métalliques à base d'hafnium sont particulièrement intéressants car ils peuvent être obtenus sous forme amorphe à l'état « massif ». En effet, d'autres alliages peuvent être obtenus à l'état amorphe mais sous la forme d'une poudre ou d'un ruban ce qui rend particulièrement difficile voire impossible la réalisation d'un doigt froid. A titre d'exemple, le document US 5,032,196 décrit plusieurs alliages métalliques à l'état amorphe qui sont obtenus sous la forme de poudres et/ou de rubans, mais pas à l'état massif. Un alliage amorphe à l'état massif est un alliage dont la plus petite dimension est supérieure à 1mm avant traitement mécanique.

Par alliage à base d'hafnium, il faut comprendre un alliage comportant au moins 17,5% atomique d'hafnium. L'alliage peut contenir du zirconium en plus de l'hafnium. Il est particulièrement avantageux que l'alliage contienne au moins 2% atomique de zirconium afin de limiter la masse volumique de l'alliage. La teneur totale en zirconium et en hafnium est inférieure ou égale à 70% atomique.

L'alliage à base d'hafnium est un alliage au moins ternaire de manière à faciliter la formation d'un alliage amorphe stable. L'alliage ternaire comporte avantageusement de l'hafnium et au moins deux éléments choisis parmi le zirconium, le cuivre, le titane et l'aluminium.

Il est avantageux que l'alliage contienne du cuivre et/ou du nickel afin de faciliter l'obtention d'un alliage à l'état amorphe.

De manière avantageuse, l'alliage à base d'hafnium est un alliage au moins quaternaire de manière à accroitre la stabilité thermique en comparaison d'un alliage ternaire et ainsi réaliser plus facilement un alliage métallique amorphe à l'état massif. L'alliage quaternaire comporte avantageusement de l'hafnium, du zirconium, du cuivre et/ou du nickel et/ou un élément choisi parmi le titane et l'aluminium.

L'alliage peut être un alliage quaternaire, quinaire ou sénaire ou plus. Les constituants de l'alliage sont choisis parmi les éléments déjà cités ci-dessus. Il est cependant possible d'utiliser d'autres éléments.

Dans le cas d'un alliage ternaire, il peut être avantageux d'utiliser un alliage choisi parmi : Hf₆₂Ni₂₅Al₁₃, Hf₆₀Ni₂₅Al₁₅, Hf₅₈Ni₂₅Al₁₇, Hf₅₅Ni2₅Al₂₀, Hf₅₃Ni₂₅Al₂₂, Hf₅₀Ni₂₅Al₂₅.

Dans le cas d'un alliage quaternaire, il peut être avantageux d'utiliser un alliage choisi parmi : Hf₅₁Cu_{27,75}Ni_{9,25}Al₁₂, Hf₄₈Cu_{29,25}Ni_{9,75}Al₁₃ et Hf₄₇Cu_{29,25}Ni_{9,75}Al₁₄.

Dans le cas d'un alliage quinaire, il peut être avantageux d'utiliser un alliage choisi parmi : Hf₄₉Ta₂Cu_{27,75}Ni_{9,25}Al_{9,25} Hf₄₆Nb₂Cu_{29,25}Ni_{9,75}Al₁₃, Hf₄₅,₅Cu_{27,8}Ni_{9,3}Ti₅Al_{12,4} et Hf_{44,5}Cu₂₇Ni_{13,5}Al₁₀Ti₅.

Par alliage au moins ternaire, on entend que les au moins trois constituants de l'alliage représentent 95% des atomes de l'alliage. Le reste de l'alliage peut être formé par des impuretés et l'impact sur des performances de l'alliage sera faible. Cependant, les autres éléments constituant l'alliage ont chacun une teneur inférieure à 1% atomique.

Il est également avantageux que lorsque le cuivre est utilisé, la teneur en cuivre de l'alliage est inférieure à 40% atomique car cela engendre des difficultés de connexion entre le doigt froid et le dispositif refroidisseur. Lorsque l'alliage contient du cuivre, il est particulièrement avantageux que la teneur totale en hafnium et éventuellement en zirconium soit supérieure ou égale à la teneur en cuivre et de préférence strictement supérieure à la teneur en cuivre de manière à réduire encore plus les difficultés de connexion entre le doigt froid et le dispositif refroidisseur.

De manière avantageuse, la teneur totale en zirconium et en hafnium est supérieure ou égale à la teneur de tout autre élément contenu dans l'alliage.

Un alliage à base d'hafnium tel que décrit précédemment et à l'état amorphe présente une conductibilité thermique qui est inférieure à 4,5 W/m/°C à 20°C ce qui représente un gain d'au moins 20% par rapport à un alliage de TA6V utilisé communément. Ce gain permet de considérer la zone du doigt froid comme un isolant thermique.

De manière encore plus avantageuse, l'alliage métallique contient au moins 20% atomique d'hafnium et de préférence entre 20% et 30% atomique pour former un alliage ayant une conductibilité thermique égale ou sensiblement égale à 4,2 W/m/K à 20°C.

Préférentiellement, l'alliage métallique contient au moins 30% atomique d'hafnium et de préférence entre 30% et 40% atomique pour former un alliage ayant une conductibilité thermique égale ou sensiblement égale à 4 W/m/K à 20°C.

Dans un mode de réalisation particulièrement avantageux, l'alliage métallique contient au moins 40% atomique et encore plus avantageusement au moins 45% atomique d'hafnium et de préférence au moins 50% atomique d'hafnium ce qui permet de former un alliage ayant une conductibilité thermique inférieure à 3,95 W/m/K à 20°C.

Par exemple, la substitution d'atomes de Zirconium par des atomes d'Hafnium permet de réduire la valeur de conductibilité thermique de l'alliage à l'état amorphe.

La conductibilité thermique de l'alliage Hf_{17,5}Zr₃₅Cu_{17,9}Ni_{14,6}Al₁₀Ti₅ est moins élevée que celle de l'alliage Zr_{52,5}Cu_{17,9}Ni_{14,6}Al₁₀Ti₅ d'au moins 5%. La conductibilité thermique de l'alliage Hf_{26,25}Zr_{26,25}Cu_{17,9}Ni_{14,6}Al₁₀Ti₅ est moins élevée que celle de l'alliage Zr_{52,5}Cu_{17,9}Ni_{14,6}Al₁₀Ti₅ d'au moins 8%. La conductibilité thermique de l'alliage Hf₃₅Zr_{17,5}Cu_{17,9}gNi_{14,6}Al₁₀Ti₅ est moins élevée que celle de l'alliage Zr_{52,5}Cu_{17,9}Ni_{14,6}Al₁₀Ti₅ d'au moins 13%. La conductibilité thermique de l'alliage Hf_{52,5}Cu_{17,9}Ni_{14,6}Al₁₀Ti₅ est moins élevée que celle de l'alliage Zr_{52,5}Cu_{17,9}Ni_{14,6}Al₁₀Ti₅ d'au moins 16%.

Plusieurs documents décrivent l'obtention d'alliages métalliques à l'état amorphe et plus particulièrement d'alliages métalliques qui contiennent par exemple de l'hafnium, du cuivre, du nickel, du titane et de l'aluminium. Les documents US 8,163,109 et US 7,645,350 décrivent des alliages amorphes pour former des projectiles. Ces documents décrivent des alliages présentant une masse volumique supérieure à 7g/cm³ et plus particulièrement supérieure à 10,5g/cm³. Cette masse volumique élevée apparait préjudiciable pour la formation d'un doigt froid performant d'un dispositif refroidisseur en comparaison de la masse volumique de l'alliage TA6V qui est égale à 4,4g/cm³. Ces valeurs de masse volumique sont d'autant plus défavorables que le module de Young des alliages présentés est sensiblement identique à celui de l'alliage TA6V.

Les inventeurs ont cependant découvert que, malgré la forte augmentation de la masse volumique avec ce type d'alliage, la configuration du doigt froid qui est une pièce creuse et statique entraine une faible dégradation des performances du dispositif refroidisseur et notamment des performances optique d'un détecteur optique placé sur la platine de refroidissement. En d'autres termes, contre toute attente, les inventeurs ont découvert que l'augmentation de la masse volumique ne se traduit pas par une dégradation nette des performances en vibration du doigt froid liées notamment aux vibrations du système de refroidissement. En effet, dans l'utilisation d'un cryostat, il convient de prendre en considération les performances en vibration du doigt froid ou de l'ensemble supporté par le doigt froid et par exemple, la fréquence de résonnance du doigt froid. La fréquence de résonnance est proportionnelle à la racine carrée du rapport E/d avec E le Module de Young et d la densité apparente.

Les inventeurs ont également découvert que les alliages à base d'hafnium sont stables chimiquement et mécaniquement ce qui permet de modifier légèrement la composition des exemples ci-dessus sans que les propriétés thermiques soient changées. Pour cette raison, la teneur en hafnium peut être changée légèrement sans que cela modifie fortement les valeurs de conductibilité thermique. Par exemple, les atomes d'hafnium peuvent être remplacés par des atomes de zirconium dans la limite de 2% atomique sans que cela ne modifie drastiquement les performances thermiques.

Il est également possible d'utiliser d'autres compositions, par exemple :
- ((HfₓZr₁₋ₓ)_{52.5}Cu_{17.9}Ni_{14.6}Al₁₀Ti₅)_{100-y}M_{y} avec x variant entre 0,1 et 1, y variant entre 0 et 3 et M choisi parmi Nb, Co, Ag, B, Si, C, Sn, Y Cr, Mn, Fe, Ga, Ge, Mo, Ta et W car ces éléments permettent d'obtenir au moins 90% volumique de phase amorphe. Pour obtenir une zone ayant au moins 90% volumique de phase amorphe, il est avantageux de choisir un élément parmi Nb, Y, Co, Fe, Ag, Si, Ge, Ge et Sn.
- (HfₓZr₁₋ₓ)₅₇Cu₂₀Ni₈Al₁₀Ti₅ avec x variant entre 0,1 et 1,
- (Hf₅₅₋ₓCu₃₀Ni₁₅)_{100-y}TiₓAl_{y} avec x égal à 0 ou 5 et y égal à 0 ou 10.

Dans un mode de réalisation particulier, le dispositif refroidisseur 1 est un cryostat, par exemple avec un vase de Dewar qui contient l'élément à refroidir. L'intérieur du cryostat est généralement soumis au vide pour limiter les entrées de chaleur. Le cryostat comporte une pompe de manière à atteindre le niveau de vide recherché. Le cryostat définit un canal d'accès à la zone à refroidir pour le passage du doigt froid 4 hors de la zone sous vide.

Le fluide utilisé par le système de refroidissement 3 de type Stirling est généralement de l'hélium ou de l'azote, sous une pression moyenne de plusieurs dizaines de bars. L'oscillateur peut être rotatif ou linéaire. Il est également possible d'utiliser un système de refroidissement 3 de type Joule-Thomson.

Pour une bonne tenue dans le temps du dispositif refroidisseur 1, il est préférable que le doigt froid 4 soit étanche au fluide utilisé par le système de refroidissement 3 pour éviter d'augmenter la consommation du refroidisseur de manière rédhibitoire et/ou de dégrader le niveau de vide à l'intérieur du cryostat.

Le sommet du doigt froid également appelé platine de refroidissement 5 est destiné à connecter thermiquement l'élément à refroidir au reste du doigt froid 1. De manière avantageuse, le sommet est réalisé en matériau cristallin, avantageusement en métal cristallin, afin d'obtenir une connexion thermique efficace avec l'élément à refroidir. En revanche, la partie supérieure de la paroi latérale est formée en métal amorphe pour réduire la conductibilité thermique dès la connexion avec l'élément à refroidir ou avec un élément intermédiaire. La platine de refroidissement 5 peut être réalisée dans un matériau rajouté sur les parois latérales ou dans une seule et même pièce avec la paroi latérale.

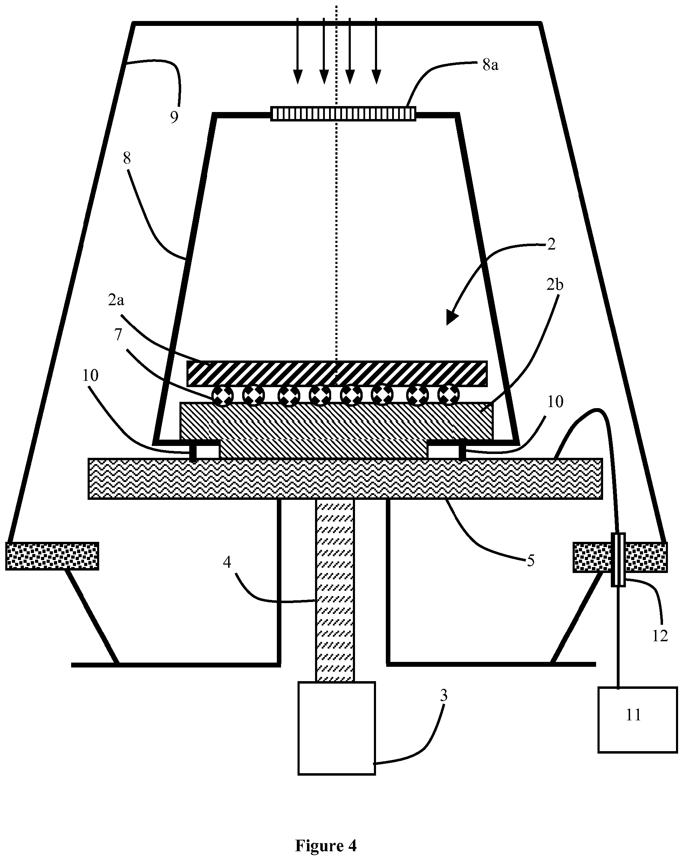

Dans les modes de réalisation illustrés aux figures 1 et 4, cette configuration permet d'avoir une partie sommitale présentant une bonne conduction thermique avec la platine de refroidissement 5 et une partie inférieure isolante thermiquement.

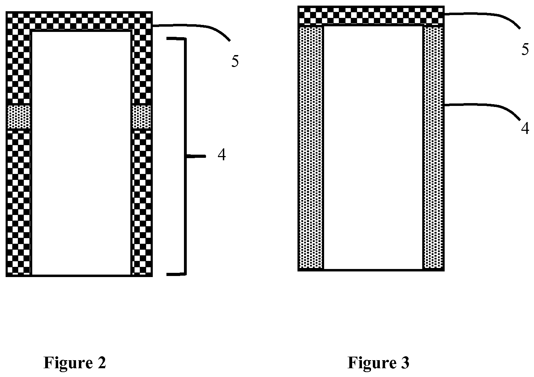

Comme illustré à la figure 2, de manière avantageuse, la zone en métal amorphe ou alliage métallique amorphe forme un anneau de manière à éviter la formation d'un canal de perte thermique entre l'élément à refroidir et une zone plus chaude. L'anneau en matériau amorphe sépare complètement le système de refroidissement 3 et la platine de refroidissement 5. Dans un mode de réalisation particulièrement avantageux illustré à la figure 3, la paroi latérale est complètement formée en alliage amorphe ce qui permet d'accroitre le caractère isolant thermique du doigt froid 4.

De manière avantageuse, le doigt froid 4 comporte également une embase 6 qui permet préférentiellement de faciliter la fixation au système de refroidissement 3. L'embase 6 peut être réalisée dans un métal amorphe identique ou différent de celui utilisé pour les parois latérales. Cependant, il est également possible d'utiliser un matériau cristallin pour former l'embase 6. Le matériau formant l'embase 6 est avantageusement réalisé dans un matériau compatible avec les assemblages à mettre en œuvre, par exemple pour permettre une soudure laser, un brasage ou une soudure électrique.

La fixation au système de refroidissement 3 peut être réalisée de différentes manières, par exemple par vissage, l'étanchéité étant assurée par des joints spécifiques.

A titre d'exemple, les parois latérales d'un doigt froid 4 ont une hauteur comprise entre 20 et 40 mm et ont un diamètre extérieur égal à 6 mm et elles ont une épaisseur comprise entre 0,08 et 0,12mm. La hauteur minimale du doigt froid est au moins égale à 10mm.

L'utilisation d'un métal amorphe permet de diminuer les pertes thermique en comparaison du même métal présenté sous sa forme monocristalline ou polycristalline. De cette manière, un doigt froid 4 formé au moins partiellement par du métal amorphe permet d'avoir une conductivité thermique réduite par rapport à un doigt froid 4 réalisé dans un matériau monocristallin ou polycristallin de composition identique ou proche. La diminution des pertes thermiques est au moins égale à 30% par rapport à un doigt froid 4 selon l'art antérieur.

La structure amorphe du matériau permet de réduire le transport d'énergie par les phonons et les électrons ce qui a pour effet d'augmenter la résistance thermique du doigt froid 4. La partie en matériau amorphe permet de transformer le doigt froid en un isolant thermique.

L'utilisation d'un matériau plus performant thermiquement permet par exemple de conserver une épaisseur de paroi latérale configurée pour assurer une bonne étanchéité du doigt froid, par exemple une bonne étanchéité du vide dans un cryostat.

En comparaison d'un doigt froid 4 en alliage de titane de type Ta6V, l'alliage à base d'hafnium sous la forme d'un alliage métallique amorphe permet une meilleure isolation thermique entre l'extrémité chaude et l'extrémité froide tout en conservant de bonnes propriétés mécaniques. Les inventeurs ont observé que l'alliage à base d'hafnium en tant qu'alliage métallique amorphe est également plus performant que les autres alliages étudiés également sous forme de verres métalliques. Les valeurs de conductibilité thermique sont plus faibles au moins à l'état massif.

Un tel dispositif de refroidissement 1 est particulièrement avantageux pour refroidir un détecteur infrarouge 2 fonctionnant à une température comprise entre 50K et 150K.

Selon les modes de réalisation, les parois latérales sont formées par le même matériau avec des régions amorphes et des régions cristallines. De manière avantageuse, toute la hauteur des parois latérales est formée par le métal amorphe ce qui permet de réduire au maximum les pertes thermiques.

Dans un mode de réalisation particulier, plusieurs matériaux différents sont utilisés pour former le doigt froid 4.

La diminution des pertes thermiques par conduction solide à travers le doigt froid 4 permet de concevoir un dispositif refroidisseur 1 qui présente une consommation réduite de son système de refroidissement 3. Il est également possible de concevoir un dispositif refroidisseur 1 plus compact car les dimensions verticales du doigt froid 4 peuvent être réduites afin de conserver des pertes thermiques sensiblement identiques à ce qui existe pour un dispositif selon l'art antérieur.

Les dispositifs de refroidissement 1 fonctionnant dans des atmosphères inertes ou contrôlées, les risques de corrosion sont limités voire nulles.

Le doigt froid reliant mécaniquement le système de refroidissement à la platine de refroidissement, aucune caractéristique magnétique particulière n'est recherchée dans cette partie du dispositif.

Comme indiqué plus haut, le dispositif refroidisseur 1 peut être utilisé dans un dispositif de détection. Le détecteur 2 ou dispositif de détection refroidi au moyen du doigt froid 1 comporte un circuit de détection 2a et un circuit de lecture 2b. Les circuits de lecture 2b et de détection 2a sont reliés électriquement de manière à ce que le circuit de lecture 2b traite l'information électrique émise par le circuit de détection 2a.

Le circuit de lecture 2b est avantageusement formé dans un premier substrat semi-conducteur et le circuit de détection 2a est hybridé sur une première face principale du circuit de lecture 2b, c'est-à-dire connecté mécaniquement et électriquement sur le circuit de lecture 2b au moyen de billes métalliques.

Le circuit de détection 2a comporte au moins un photodétecteur transformant un signal optique en un signal électrique. De manière préférentielle, le circuit de détection 2a comporte une pluralité de photodétecteurs. A titre d'exemple, le photodétecteur est une photodiode, un dispositif à puits quantiques ou à multipuits quantiques. Dans un mode de réalisation préférentiel, le photodétecteur réalise la détection dans le domaine de l'infrarouge. A titre d'exemple, le circuit de lecture 2b réalise la polarisation du circuit de détection 2a et la transformation d'un signal en courant émis par le photodétecteur en un signal en tension.

Dans un mode de réalisation particulier qui peut être combiné aux précédents, le circuit de détection 2a est formé sur un premier substrat semi-conducteur et le circuit de lecture 2b est formé sur un second substrat semi-conducteur de manière à obtenir simultanément de bonnes caractéristiques de détection et de bonnes performances électriques du circuit de lecture 2b. Les deux substrats sont formés dans des matériaux différents. Avantageusement, l'un des deux substrats ou les deux substrats sont monocristallins. A titre d'exemple, le substrat du circuit de détection 2a est un matériau dit II-VI, par exemple à base de HgCdTe et le substrat du circuit de lecture 2b est un substrat à base de silicium. De manière avantageuse, les substrats en matériau II-VI sont refroidis afin de fournir des performances de détection accrues. Il est également possible d'utiliser un matériau dit III-V, par exemple à base de InSb ou InGaAs.

Pour obtenir un système compact, les deux circuits sont avantageusement hybridés et ils forment le composant hybridé. L'hybridation des deux substrats est avantageusement réalisée par une ou plusieurs billes 7 en matériau électriquement conducteur qui sont disposées entre les deux circuits. Le circuit de détection 2a est hybridé sur une première face principale du circuit de lecture 2b de manière à former un ensemble monobloc et à faciliter la connexion électrique entre ces deux circuits. La première face principale du circuit de lecture 2b est avantageusement formée par une couche en matériau électriquement isolant qui recouvre le substrat semi-conducteur et à l'intérieur de laquelle sont disposées des lignes électriquement conductrices. La deuxième face principale du circuit de lecture 2b est par exemple la face arrière du substrat semi-conducteur.

Un écran froid 8 (ou coldshield en anglais) est fixé sur le circuit de lecture 2b ou sur une table froide. L'écran froid 8 est fixé de manière à entourer le circuit de détection 2a présent sur la première face principale du circuit de lecture 2b. L'écran froid 8 peut comporter une lentille 8a.

L'écran froid 8 est réalisé principalement dans un matériau opaque au rayonnement à détecter afin de former une zone opaque. L'écran froid 8 comporte une zone transparente au rayonnement à détecter, ce qui permet de définir la zone d'observation du circuit de détection 2a. L'axe optique X du circuit de détection 2a traverse la zone transparente. La zone transparente peut être formée par un trou ou par un dispositif optique, par exemple une ou plusieurs lentilles qui sont utilisées pour délimiter la zone d'observation du dispositif de détection. De cette manière, le rayonnement incident traverse l'écran froid 8 avant d'être capté par le circuit de détection 2a. Dans le mode de réalisation illustré, l'écran froid 8 est posé directement sur le circuit de lecture, mais il est également envisageable de poser l'écran froid 8 sur une table froide séparant le circuit de lecture et le doigt froid.

Dans un mode de réalisation avantageux illustré à la figure 4, le dispositif de détection comporte un cryostat muni d'un vase Dewar 9 qui incorpore le détecteur 2. Le cryostat est mis sous vide pour limiter la formation de courants convectifs gazeux et conductifs qui perturbent le fonctionnement du détecteur 2. Le doigt froid 1 est introduit dans le cryostat de manière à se coupler thermiquement au détecteur 2.

Dans cette configuration, des efforts mécaniques supplémentaires sont appliqués au doigt froid 1. La partie interne du doigt froid 1 est soumise à une pression de plusieurs bars alors que la partie externe est placée sous vide, par exemple à une pression de l'ordre de 10⁻⁵mbar.

De manière préférentielle, le volume interne du cryostat est à une pression sub-atmosphérique. Dans un mode de réalisation avantageux, le circuit de détection 2a est placé sous vide pour diminuer les échanges thermiques par convection de cette partie du dispositif. La partie externe du cryostat peut alors être en contact avec une zone chaude tandis que le doigt froid 4 sert pour le refroidissement du détecteur 2.

Dans un mode de réalisation particulièrement avantageux, le circuit de lecture 2b comporte un ou plusieurs plots de connexion 10 qui sont situés à l'extérieur de la surface délimitée par l'écran froid 8. Ces plots de connexion 10 permettent la transmission de signaux électriques depuis le circuit de lecture 2b vers d'autres circuits du dispositif de détection, par exemple un circuit de traitement 11 qui est configuré pour traiter l'image envoyée par le circuit de lecture 2b et/ou qui est configuré pour modifier la trajectoire d'un objet mobile sur lequel se trouve le dispositif de détection.

Le plot de connexion 8 est relié au reste du circuit de lecture 2b au moyen d'un fil électriquement conducteur qui circule à l'intérieur du circuit de lecture 2b. De cette manière, il est possible d'avoir une surface plane assurant une connexion mécanique importante entre l'écran froid 8 et le circuit de lecture 2b, une très bonne opacité au rayonnement parasite et une étanchéité accrue au rayonnement. Cette configuration est particulièrement avantageuse dans le cas où le circuit de détection 2a est dans une atmosphère contrôlée voire sous vide car la fiabilité du dispositif est accrue. La connexion électrique entre le circuit de lecture 2b et le circuit de traitement 11 est réalisée à l'extérieur de l'espace fermé au moyen de connecteurs. Les connecteurs partent du circuit de lecture 2b hors de la surface fermée définie par la connexion avec l'écran froid 8.

Le circuit de détection 2a est destiné à être relié thermiquement à la source froide formée par le système de refroidissement 3 afin de travailler à une température réduite. Dans le mode de réalisation particulier illustré aux figures 1 et 4, le dispositif comporte une table froide formant la platine de refroidissement sur laquelle le circuit de lecture 2b est fixé. La table froide agit comme un support mécanique pour le composant hybridé. De manière avantageuse, la table froide est reliée électriquement au circuit de lecture 2b et elle participe dans le transit des signaux électriques vers le circuit de traitement 11. La seconde face principale du circuit de lecture 2b peut être fixée directement à la table froide.

Dans cette configuration, il y a successivement, la table froide, le circuit de lecture 2b et le circuit de détection 2a. La table froide est destinée à être reliée thermiquement au système de refroidissement 3 et le froid est imposé au circuit de lecture 2b et au circuit de détection 2a par l'intermédiaire de la table froide. En d'autres termes, la table froide est destinée à réaliser la connexion thermique entre le circuit de détection 2a et le système de refroidissement 3.

Lorsqu'un cryostat est utilisé, une connexion électrique additionnelle 12, traverse le cryostat pour relier le détecteur au circuit de traitement 11.

En alternative, la platine de refroidissement 5 n'est pas configurée pour recevoir un élément à refroidir ou le dispositif refroidisseur comporte plusieurs platines de refroidissement 5 dont certaines ne sont pas utilisées pour refroidir un détecteur ou un autre dispositif. La platine de refroidissement 5 permet de fixer les impuretés présentes dans le cryostat afin de les piéger. L'atmosphère dans le cryostat est alors plus propre.

Dans un mode de réalisation particulier, le doigt froid est relié à la masse électrique de manière à évacuer des charges parasites qui pourraient entrainées une dégradation du circuit de lecture et/ou du circuit de détection par exemple au moyen d'une décharge électrostatique.

## Revendications

1. Dispositif refroidisseur comportant :
- une platine de refroidissement (5),
- un système de refroidissement (3) muni d'un fluide de refroidissement,
- un doigt froid (4) creux et fermé à une extrémité par la platine de refroidissement (5), le fluide de refroidissement étant localisé dans le doigt froid (4) pour refroidir la platine de refroidissement (5), le doigt froid (4) comportant au moins une paroi latérale définissant un canal de confinement du fluide de refroidissement depuis le système de refroidissement (3),
- ladite au moins une paroi latérale étant formée au moins partiellement par une zone en alliage métallique au moins partiellement amorphe de manière à former un isolant thermique,
dispositif refroidisseur **caractérisé en ce que**:
- la zone en alliage métallique au moins partiellement amorphe est formée par un alliage au moins ternaire contenant au moins 17,5% atomique d'hafnium et éventuellement du cuivre avec une teneur maximale égale à 40% atomique de cuivre.

2. Dispositif refroidisseur selon la revendication 1 **caractérisé en ce que** l'alliage métallique contient au moins 20% atomique d'hafnium.

3. Dispositif refroidisseur selon la revendication 2 **caractérisé en ce que** l'alliage métallique contient au moins 30% atomique d'hafnium.

4. Dispositif refroidisseur selon la revendication 3 **caractérisé en ce que** l'alliage métallique contient au moins 40% atomique d'hafnium.

5. Dispositif refroidisseur selon la revendication 4 **caractérisé en ce que** l'alliage métallique contient au moins 50% atomique d'hafnium.

6. Dispositif refroidisseur selon l'une quelconque des revendications précédentes, **caractérisé en ce que** l'alliage métallique contient du zirconium et **en ce que** la teneur totale en hafnium et en zirconium est inférieure ou égale à 70% atomique.

7. Dispositif refroidisseur selon l'une quelconque des revendications précédentes, **caractérisé en ce que** l'alliage métallique contient du zirconium et **en ce que** la teneur totale en hafnium et en zirconium est supérieure à la teneur en tout autre élément de l'alliage métallique.

8. Dispositif refroidisseur selon l'une quelconque des revendications précédentes **caractérisé en ce que** l'alliage métallique contient du cuivre et **en ce que** la teneur en cuivre est inférieure à la teneur totale en hafnium et éventuellement en zirconium.

9. Dispositif refroidisseur selon l'une quelconque des revendications précédentes **caractérisé en ce que** l'alliage métallique au moins partiellement amorphe est choisi parmi les alliages de Hf_{52,5}Cu_{17,9}Ni_{14,6}Al₁₀Ti₅, H₃₅Zr_{17,5}Cu_{17,9}Ni_{14,6}Al₁₀Ti₅, Hf_{17,5}Zr₃₅Cu_{17,9}Ni_{14,6}Al₁₀Ti₅ et Hf_{26,25}Zr_{26,25}Cu_{17,9}Ni_{14,6}Al₁₀Ti₅

10. Dispositif refroidisseur selon l'une des quelconque des revendications 1 à 8 **caractérisé en ce que** l'alliage métallique au moins partiellement amorphe est choisi parmi les alliages de ((HfₓZr₁₋ₓ)_{52.5}Cu_{17.9}Ni_{14.6}Al₁₀Ti₅)_{100-y}M_{y} avec x variant entre 0,1 et 1, y variant entre 0 et 3 et M choisi parmi Nb, Co, Ag, B, Si, C, Sn, Y Cr, Mn, Fe, Ga, Ge, Mo, Ta et W, (HfₓZr₁₋ₓ)₅₇Cu₂₀Ni₈Al₁₀Ti₅ avec x variant entre 0,1 et 1 et (Hf₅₅₋ₓCu₃₀Ni₁₅)_{100-y}TiₓAl_{y} avec x égal à 0 ou 5 et y égal à 0 ou 10.

11. Dispositif refroidisseur selon l'une des quelconque des revendications 1 à 8 **caractérisé en ce que** l'alliage métallique au moins partiellement amorphe est choisi parmi les alliages Hf₆₂Ni₂₅Al₁₃, Hf₆₀Ni₂₅Al₁₅, Hf₅₈Ni₂₅Al₁₇, Hf₅₅Ni₂₅Al₂₀, Hf₅₃Ni₂₅Al₂₂, Hf₅₀Ni₂₅Al₂₅, Hf₅₁Cu_{27,75}Ni_{9,25}Al₁₂, Hf₄₈Cu_{29,25}Ni_{9,75}Al₁₃, Hf₄₇Cu_{29,25}Ni_{9,75}Al₁₄, Hf49Ta₂Cu_{27,75}Ni_{9,25}Al₁₂, Hf₄₆Nb₂Cu_{29,25}Ni_{9,75}Al₁₃, Hf_{45,5}Cu_{27,8}Ni_{9,3}Ti₅Al_{12,4} et Hf_{44,5}Cu₂₇Ni_{13,5}Al₁₀Ti₅.

12. Dispositif refroidisseur selon l'une quelconque des revendications précédentes, **caractérisé en ce que** la zone en alliage métallique au moins partiellement amorphe forme un anneau séparant complètement le système de refroidissement (3) et la platine de refroidissement (5).

13. Dispositif refroidisseur selon l'une quelconque des revendications précédentes, **caractérisé en ce que** la au moins une paroi latérale est complètement formée par un alliage métallique au moins partiellement amorphe de manière à relier le système de refroidissement (3) et la platine de refroidissement (5).

14. Dispositif refroidisseur selon l'une quelconque des revendications précédentes, **caractérisé en ce qu'**un photodétecteur (2) est connecté à la platine de refroidissement (5).

15. Dispositif refroidisseur selon l'une quelconque des revendications précédentes, **caractérisé en ce que** le doigt froid (4) est sous atmosphère inerte.

## Patentansprüche

1. Kühlvorrichtung, umfassend:
- eine Kühlplatine (5),
- ein Kühlsystem (3), das mit einer Kühlflüssigkeit versorgt wird,
- einen Kryostatfinger (4), der hohl und an einem Ende durch die Kühlplatine (5) verschlossen ist, wobei sich die Kühlflüssigkeit im Kryostatfinger (4) befindet, um die Kühlplatine (5) zu kühlen, wobei der Kryostatfinger (4) mindestens eine Seitenwand umfasst, die einen Kanal zum Einschließen der Kühlflüssigkeit aus dem Kühlsystem (3) definiert,
- wobei die mindestens eine Seitenwand mindestens teilweise durch eine Zone aus einer mindestens teilweise amorphen Metalllegierung gebildet ist, um einen thermischen Isolator zu bilden,
wobei die Kühlvorrichtung **dadurch gekennzeichnet ist, dass**:
- die mindestens teilweise amorphe Metalllegierungszone aus einer mindestens ternären Legierung gebildet ist, die mindestens 17,5 Atom-% Hafnium und optional Kupfer mit einem maximalen Gehalt von 40 Atom-% Kupfer enthält.

2. Kühlvorrichtung nach Anspruch 1, **dadurch gekennzeichnet, dass** die Metalllegierung mindestens 20 Atom-% Hafnium enthält.

3. Kühlvorrichtung nach Anspruch 2, **dadurch gekennzeichnet, dass** die Metalllegierung mindestens 30 Atom-% Hafnium enthält.

4. Kühlvorrichtung nach Anspruch 3, **dadurch gekennzeichnet, dass** die Metalllegierung mindestens 40 Atom-% Hafnium enthält.

5. Kühlvorrichtung nach Anspruch 4, **dadurch gekennzeichnet, dass** die Metalllegierung mindestens 50 Atom-% Hafnium enthält.

6. Kühlvorrichtung nach einem der vorhergehenden Ansprüche, **dadurch gekennzeichnet, dass** die Metalllegierung Zirkonium enthält und dass der Gesamtgehalt an Hafnium und Zirkonium kleiner oder gleich 70 Atom-% ist.

7. Kühlvorrichtung nach einem der vorhergehenden Ansprüche, **dadurch gekennzeichnet, dass** die Metalllegierung Zirkonium enthält und dadurch, dass der Gesamtgehalt an Hafnium und Zirkonium höher ist als der Gehalt an jedem anderen Element in der Metalllegierung.

8. Kühlvorrichtung nach einem der vorhergehenden Ansprüche, **dadurch gekennzeichnet, dass** die Metalllegierung Kupfer enthält und dadurch, dass der Gehalt an Kupfer geringer ist als der Gesamtgehalt an Hafnium und gegebenenfalls Zirkonium.

9. Kühlvorrichtung nach einem der vorhergehenden Ansprüche, **dadurch gekennzeichnet, dass** die mindestens teilweise amorphe Metalllegierung ausgewählt ist aus den Legierungen Hf_{52,5}Cu_{17,9}Ni_{14,6}Al₁₀Ti_{5,}Hf₃₅Zr_{17,5}Cu_{17,9}Ni_{14,6}Al₁₀Ti₅, Hf_{17,5}Zr₃₅Cu_{17,9}Ni_{14,6}Al₁₀Ti₅ und Hf_{26,25}Zr_{26,25}Cu_{17,9}Ni_{14,6}Al₁₀Ti₅.

10. Kühlvorrichtung nach einem der Ansprüche 1 bis 8, **dadurch gekennzeichnet, dass** die mindestens teilweise amorphe Metalllegierung ausgewählt ist aus den Legierungen ((HfₓZr₁₋ₓ) _{52.5}Cu_{17.9}Ni_{14.6}Al₁₀Ti₅) _{100-y}M_{y}, wobei x zwischen 0,1 und 1 variiert, y zwischen 0 und 3 variiert und M ausgewählt ist aus Nb, Co, Ag, B, Si, C, Sn, Y Cr, Mn, Fe, Ga, Ge, Mo, Ta und W, (HfₓZr₁-ₓ) ₅₇Cu₂₀Ni₈Al₁₀Ti₅ wobei x zwischen 0,1 und 1 variiert und (Hf₅₅₋ₓCu₃₀Ni₁₅) _{100-y}TiₓAl_{y} wobei x gleich 0 oder 5 und y gleich 0 oder 10 ist.

11. Kühlvorrichtung nach einem der Ansprüche 1 bis 8, **dadurch gekennzeichnet, dass** die mindestens teilweise amorphe Metalllegierung ausgewählt ist aus den Legierungen Hf₆₂Ni₂₅Al₁₃, Hf₆₀Ni₂₅Al₁₅, Hf₅₈Ni₂₅Al₁₇, Hf₅₅Ni₂₅Ab₂₀, Hf₅₃Ni₂₅Al₂₂, Hf₅₀Ni₂₅Al₂₅, Hf₅₁Cu_{27,75}Ni_{9,25}Al₁₂, Hf₄₈Cu_{29,25}Ni_{9,75}Al₁₃, Hf₄₇Cu_{29,25}N_{19,75}Al₁₄, Hf₄₉Ta₂Cu_{27,75}Ni_{9,25}Al₁₂, Hf₄₆Nb₂Cu_{29,25}Ni_{9,75}Al₁₃, Hf_{45,5}Cu_{27,8}Ni_{9,3}Ti₅Al_{12,4} und Hf_{44,5}Cu₂₇Ni_{13,5}Al₁₀Ti₅.

12. Kühlvorrichtung nach einem der vorhergehenden Ansprüche, **dadurch gekennzeichnet, dass** die mindestens teilweise amorphe Metalllegierungszone einen Ring bildet, der das Kühlsystem (3) und die Kühlplatine (5) vollständig trennt.

13. Kühlvorrichtung nach einem der vorhergehenden Ansprüche, **dadurch gekennzeichnet, dass** die mindestens eine Seitenwand vollständig aus einer mindestens teilweise amorphen Metalllegierung gebildet ist, um das Kühlsystem (3) und die Kühlplatine (5) zu verbinden.

14. Kühlvorrichtung nach einem der vorhergehenden Ansprüche, **dadurch gekennzeichnet, dass** ein Photodetektor (2) mit der Kühlplatine (5) verbunden ist.

15. Kühlvorrichtung nach einem der vorhergehenden Ansprüche, **dadurch gekennzeichnet, dass** sich der Kryostatfinger (4) in einer inerten Atmosphäre befindet.

## Claims

1. Cooling device comprising:
- a cooling plate (5),
- a cooling system (3) provided with a cooling fluid,
- a hollow cold finger (4) closed at one end by the cooling plate (5), the cooling fluid being located in the cold finger (4) to cool the cooling plate (5), the cold finger (4) comprising at least one side wall defining a confinement channel of the cooling fluid from the cooling system (3),
- said at least one side wall being at least partially formed by an area made from at least partially amorphous metal alloy so as to form a thermal insulator,
cooling device **characterized in that**:
- the area made from at least partially amorphous metal alloy is formed by an at least ternary alloy containing at least 17.5% in atomic % of hafnium and possibly of copper with a maximum content equal to 40% in atomic % of copper.

2. Cooling device according to claim 1, **characterized in that** the metal alloy contains at least 20% in atomic % of hafnium.

3. Cooling device according to claim 2, **characterized in that** the metal alloy contains at least 30% in atomic % of hafnium.

4. Cooling device according to claim 3, **characterized in that** the metal alloy contains at least 40% in atomic % of hafnium.

5. Cooling device according to claim 4, **characterized in that** the metal alloy contains at least 50% in atomic % of hafnium.

6. Cooling device according to any one of the foregoing claims, **characterized in that** the metal alloy contains zirconium and **in that** the total content of hafnium and zirconium is less than or equal to 70% in atomic %.

7. Cooling device according to any one of the foregoing claims, **characterized in that** the metal alloy contains zirconium and **in that** the total content of hafnium and zirconium is greater than the content of any other element of the metal alloy.

8. Cooling device according to any one of the foregoing claims, **characterized in that** the metal alloy contains copper and **in that** the copper content is less than the total content of hafnium and of zirconium if applicable.

9. Cooling device according to any one of the foregoing claims, **characterized in that** the at least partially amorphous metal alloy is chosen from alloys of Hf_{52.5}Cu_{17.9}Ni_{14.6}Al₁₀Ti₅, Hf₃₅Zr_{17.5}Cu_{17.9}Ni_{14.6}Al₁₀Ti₅, Hf_{17.5}Zr₃₅Cu_{17.9}Ni_{14.6}Al₁₀Ti₅ and Hf_{26.5}Zr_{26.25}Cu_{17.9}Ni_{14.6}Al₁₀Ti₅.

10. Cooling device according to any one of claims 1 to 8, **characterized in that** the at least partially amorphous metal alloy is chosen from alloys of ((HfₓZr₁₋ₓ)_{52.5}Cu_{17.9}Ni_{14.6}Al₁₀Ti₅)_{100-y}M_{y} with x varying between 0.1 and 1, y varying between 0 and 3 and M chosen from Nb, Co, Ag, B, Si, C, Sn, Y Cr, Mn, Fe, Ga, Ge, Mo, Ta and W, (HfₓZr₁₋ₓ)₅₇Cu₂₀Ni₈Al₁₀Ti₅ with x varying between 0.1 and 1 and (Hf₅₅₋ₓCu₃₀Ni₁₅)_{100-y}TiₓAl_{y} with x equal to 0 or 5 and y equal to 0 or 10.

11. Cooling device according to any one of claims 1 to 8, **characterized in that** the at least partially amorphous metal alloy is chosen from the alloys Hf₆₂Ni₂₅Al₁₃, Hf₆₀Ni₂₅Al₁₅, Hf₅₈Ni₂₅Al₁₇, Hf₅₅Ni₂₅Al₂₀, Hf₅₃Ni₂₅Al₂₂, Hf₅₀Ni₂₅Al₂₅, Hf₅₁Cu_{27.75}Ni_{9.25}Al₁₂, Hf₄₈Cu_{29.25}Ni_{9.75}Al₁₃, Hf₄₇Cu_{29.25}Ni_{9.75}Al₁₄, Hf₄₉Ta₂Cu_{27.75}Ni_{9.25}Al₁₂, Hf₄₆Nb₂Cu_{29.25}Ni_{9.75}Al₁₃, Hf_{45.5}Cu_{27.8}Ni_{9.3}Ti₅Al_{12.4} and Hf_{44.5}Cu₂₇Ni_{13.5}Al₁₀Ti₅.

12. Cooling device according to any one of the foregoing claims, **characterized in that** the area made from at least partially amorphous metal alloy forms a ring completely separating the cooling system (3) and the cooling plate (5).

13. Cooling device according to any one of the foregoing claims, **characterized in that** the at least one side wall is completely formed by the at least partially amorphous metal alloy so as to connect the cooling system (3) and the cooling plate (5).

14. Cooling device according to any one of the foregoing claims, **characterized in that** a photodetector (2) is connected to the cooling plate (5).

15. Cooling device according to any one of the foregoing claims, **characterized in that** the cold finger (4) is in an inert atmosphere.
